# EUROPÄISCHE PATENTSCHRIFT

(11) **EP 2 734 693 B1**
(45) Veröffentlichungstag und Bekanntmachung des Hinweises auf die Patenterteilung: **22.04.2015**
(21) Anmeldenummer: 12727295.3
(22) Anmeldetag: 30.05.2012
(51) Int. Cl.: E05B 17/22, H05K 3/36, H05K 1/02, E05B 9/02, E05B 63/00

(54) **EINSTECKSCHLOSS MIT EINER PLATINE**
MORTISE LOCKS WITH PRINTED CIRCUIT BOARD
SERRURE À MORTAISE AVEC PLATINE

(30) Priorität: 19.07.2011 DE 102011051948
(43) Veröffentlichungstag der Anmeldung: 28.05.2014
(73) Patentinhaber: DORMA Deutschland GmbH, 58256 Ennepetal (DE)
(72) Erfinder: GRÖNE, Kai, 58455 Witten (DE); SUBERG, Michael, 42899 Remscheid (DE); SCHNEIDER, Marc-André, 58256 Ennepetal (DE)
(74) Vertreter: Balder IP Law, S.L.
(86) Internationale Anmeldenummer: PCT/EP2012/002271
(87) Internationale Veröffentlichungsnummer: WO 2013/010607

(56) Entgegenhaltungen:
- WO-A1-03/033845
- DE-U1- 20 022 102

## Beschreibung

Die vorliegende Erfindung betrifft ein Einsteckschloss mit einer Platine zur Verwendung von Zustandsabfragen und/oder motorischen Steuerungen von einzelnen Komponenten der Schlossmechanik des Einsteckschlosses. Weiterhin ist die Platine derart ausgelegt, dass sie zur Steuerung einer mechatronischen Zuschalteinheit verwendet werden kann. Die Einsteckschlösser weisen einander gegenüber unterschiedliche Dornmaße auf.

Für jedes Einsteckschloss werden im Stand der Technik spezielle Platinen für unterschiedliche Dornmaße offenbart, wobei sie den Nachteil haben, dass eine Vielzahl von Platinen-Varianten vorgehalten werden müssen, um die jeweiligen Einsteckschlösser mit unterschiedlichen Dornmaßen bestücken zu können.

Es ist daher die Aufgabe der vorliegenden Erfindung, ein Einsteckschloss bereitzustellen, das einen einfachen Aufbau besitzt, kostengünstig herzustellen ist und an unterschiedliche Dornmaße angepasst werden kann, wodurch bei der Platine die Variantenvielfalt minimiert wird.

Diese Aufgabe wird ausgehend von einem Einsteckschloss gemäß dem Oberbegriff des Anspruches 1 in Verbindung mit den kennzeichnenden Merkmalen gelöst. Vorteilhafte Weiterbildungen der Erfindung sind in den abhängigen Ansprüchen angegeben.

Die Erfindung schließt die technische Lehre ein, dass die Platine aus einer ersten und einer zweiten Platine besteht, die mit einem Leiterplattenverbinder und einem Kontaktpad verbunden sind, wobei auf der ersten Platine das Kontaktpad angeordnet ist, welches an ein Dornmaß des Einsteckschlosses anpassbar ist, und dass auf der zweiten Platine der Leiterplattenverbinder und der Steckkontakt angeordnet sind.

Von Vorteil ist, dass das Kontaktpad Leiterbahnen aufweist. Da der Leiterplattenverbinder aufgrund von Zentrierdomen in das Kontaktpad einführbar ist, können die erforderlichen Leiterbahnen sehr einfach kontaktiert werden.

Vorteilig ist, dass an dem Kontaktpad Schneidkanten ausgebildet sind. Die Schneidkante ist durch eine Kerbe gebildet, die im Bereich des Kontaktpads angeordnet ist, wodurch die Materialstärke der ersten Platine in diesem Bereich verringert wird. Sinnvollerweise ist die Kerbe als V-Form ausgebildet, da diese Form von Einkerbungen einfach und kostengünstig herzustellen ist. Weitere Formen von Einkerbungen sind denkbar. Sinnvollerweise sind im Abschnitt des Kontaktpads weitere Schneidkanten vorgesehen, um eine Dornmaßabstufung gewährleisten zu können.

Auch von Vorteil ist, dass das Kontaktpad Paare von Zentrierbohrungen aufweist. Die Zentrierbohrungen dienen der Aufnahme von Zentrierdomen, die an dem Leiterpalttenverbinder angeordnet sind, wodurch eine einfache Aufnahme für den Leiterpalttenverbinder bereitgestellt ist.

Ebenfalls vorteilig ist, dass an dem Leiterplattenverbinder Zentrierdome angeordnet sind. Die Zentrierdome sind in dieser Ausführungsform bereits zum Leiterplattenverbinder ausgerichtet, wobei die Zentrierdome auf einfache Weise ausgerichtet herstellbar sind.

Vorteilig ist, dass die Zentrierbohrungen mit den Zentrierdomen zusammenwirken. Durch das Zusammenwirken der Zentrierbohrungen mit den Zentrierdomen wird eine Ausrichtung und Zentrierung der zweiten Platine zu der ersten Platine gewährleistet.

Von Vorteil ist, dass benachbarte Paare von Zentrierbohrungen jeweils eine Beabstandung aufweisen, die einer Dornmaßstufung entspricht. Somit kann der Leiterplattenverbinder aufgrund von Zentrierdomen in ein entsprechendes Paar von Zentrierbohrungen eingreifen, welches dem Dornmaß eines relevanten zu nutzenden Einsteckschlosses entspricht, wobei ein Dornmaß beispielsweise 5 Millimeter (5mm) entspricht.

Ebenso vorteilig ist, dass die paarweise angeordneten Zentrierbohrungen auf einer Ebene von zugeordneten Schneidkanten angeordnet sind. Durch das Entfernen eines Teilbereiches des Kontaktpads werden aufgrund der jeweiligen Schneidkante die jeweiligen auf dieser Ebene befindlichen Zentrierbohrungen für die Zentrierung der zweiten Platine mit der ersten Platine unbrauchbar, um sicher zu stellen, dass durch die Nutzung von verbleibenden Zentrierbohrungen des Kontaktpads eine Dornmaßstufung genutzt wird.

Vorteilig ist auch, dass aufgrund der Schneidkante ein Teilabschnitt des Kontaktpads von Hand oder einem Werkzeug entfernbar ist. Hierdurch kann auf einfache Weise ein überschüssiger Teilbereich des Kontaktpads von der ersten Platine entfernt werden.

Vorteilig wird sein, dass der Leiterplattenverbinder bei der Verbindung der ersten Platine mit der zweiten Platine aufgrund der Zentrierdome und den Zentrierbohrungen die zweite Platine zu der ersten Platine ausrichtet und zentriert. Durch die Ausrichtung und der Zentrierung ist eine sichere Kontaktierung zwischen dem Leiterplattenverbinder und den Leiterbahnen der ersten Platine gewährleistet, wobei die Montage auf einfache Weise durchgeführt werden kann.

Ein weiterer Vorteil besteht darin, dass die Zentrierdome in die paarweise angeordneten Zentrierbohrungen des Kontaktpads einführbar sind. Hierdurch ist sichergestellt, dass eine Kontaktierung der ersten Platine mit der zweiten Platine aufgrund des Leiterplattenverbinders gegeben ist, da die Zentrierdome die zweite Platine zu der ersten Platine ausrichtet und zentriert.

Ebenso vorteilig ist, dass der Leiterplattenverbinder die Leiterbahnen des Kontaktpads kontaktiert. Somit sind die Leiterbahnen auf einfache Weise aufgrund des Leiterplattenverbinders zu kontaktieren.

Weitere, die Erfindung verbessernde Maßnahmen werden nachstehend gemeinsam mit der Beschreibung von bevorzugten Ausführungsbeispielen der Erfindung anhand der Figuren näher darstellt.

Es zeigt:
- Figur 1: ein erstes Einsteckschloss ohne Gehäuseabdeckung in einer perspektivischen Ansicht, wobei zur besseren Übersicht die Schlossmechanik entfernt ist,
- Figur 2: das erste Einsteckschloss aus der Figur 1 in einer Draufsicht,
- Figur 3: ein zweites Einsteckschloss ohne Gehäuseabdeckung in einer Draufsicht, wobei ein Teil einer ersten Platine aus dem Gehäuse herausragt, wobei zur besseren Übersicht die Schlossmechanik entfernt ist,
- Figur 4: das zweite Einsteckschloss aus der Figur 3, wobei der aus dem Gehäuse herausragende Teil der ersten Platine entfernt ist,
- Figur 5: die erste Platine in einer perspektivischen Ansicht,
- Figur 6: die erste Platine aus der Figur 5 in einer Draufsicht mit einer Detailangabe,
- Figur 7: die Detailangabe aus der Figur 6 vergrößert dargestellt,
- Figur 8: die erste Platine aus der Figur 6, wobei ein Teil der Platine entfernt ist, welches der Darstellung der ersten Platine in der Figur 4 entspricht,
- Figur 9: eine zweite Platine in einer perspektivischen Ansicht,
- Figur 10: die zweite Platine aus der Figur 9 in einer Draufsicht,
- Figur 11: die erste Platine und die zweite Platine, die miteinander verbunden sind, in einer perspektivischen Ansicht,
- Figur 12: die erste Platine und die zweite Platine, die miteinander verbunden sind, in einer weiteren perspektivischen Ansicht mit einer Detailangabe,
- Figur 13: die Detailangabe aus der Figur 12 vergrößert dargestellt,

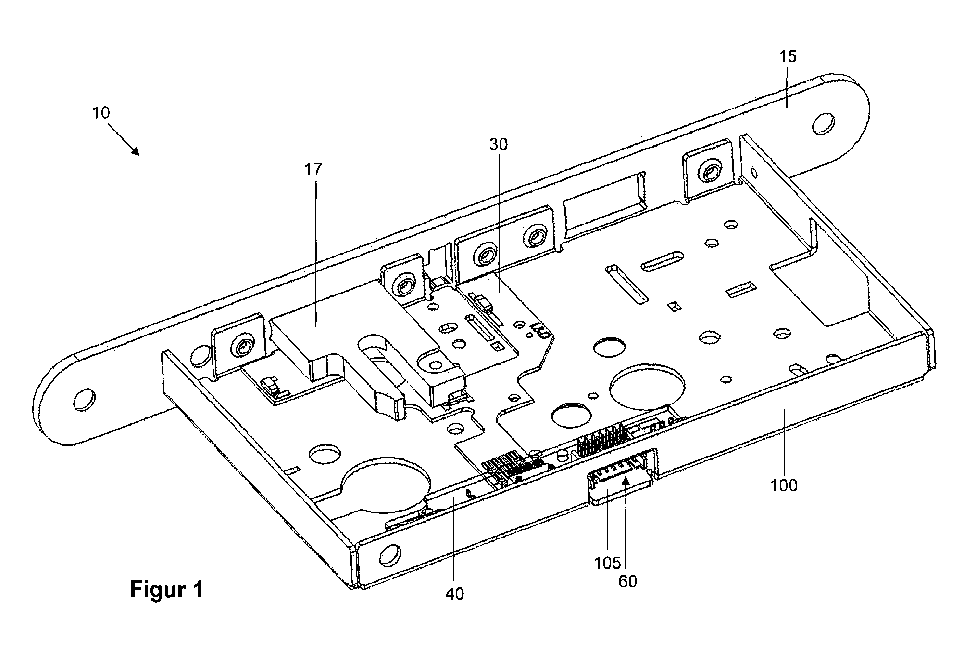

Figur 1 zeigt ein erstes Einsteckschloss 10 in einer perspektivischen Ansicht, wobei eine Gehäuseabdeckung eines ersten Einsteckschlosses 10 entfernt ist, um einen Einblick in ein erstes Gehäuse 100 zu ermöglichen. Zur besseren Übersicht ist die Schlossmechanik ebenfalls entfernt, da sie für die Darstellung der Erfindung unerheblich ist. An dem ersten Gehäuse 100 ist ein Stulp 15 angeordnet, der Öffnungen aufweist, wobei eine dieser Öffnungen durch einen Riegel 17 genutzt wird, um ihn aufgrund der nicht dargestellten Schlossmechanik in das erste Gehäuse 100 hinein oder herausführen zu können. Das erste Gehäuse 100 weist eine Öffnung 105 auf, durch die ein Stecker von außerhalb des ersten Gehäuses 100 zu einem Steckkontakt 60 geführt werden kann. Dieser Steckkontakt 60 ist an einer zweiten Platine 40 angeordnet, die innerhalb des ersten Gehäuses 100 angeordnet ist. Die zweite Platine 40 ist mit einer ersten Platine 30 elektrisch sowie elektronisch verbunden, wobei die erste Platine 30 ebenfalls innerhalb des ersten Gehäuses 100 angeordnet ist.

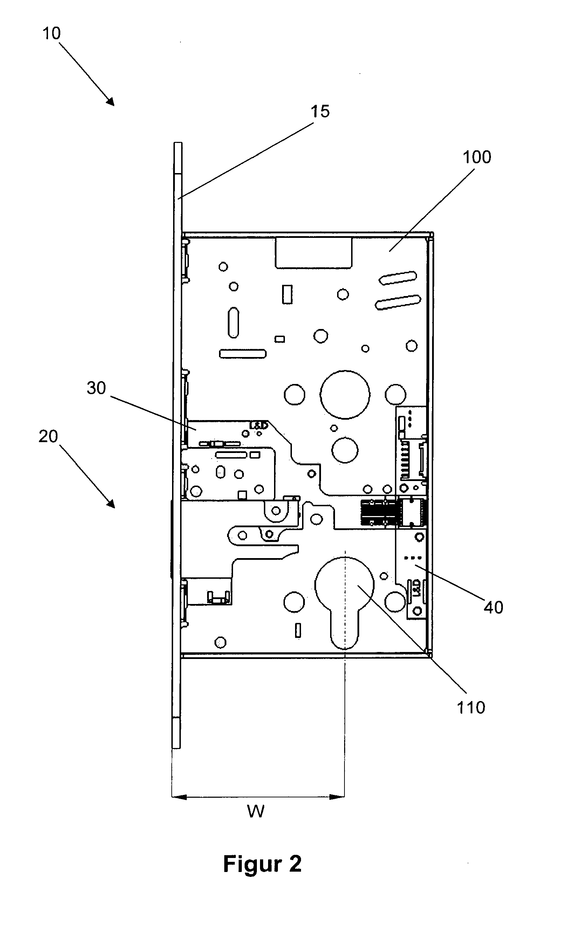

Figur 2 zeigt das erste Einsteckschloss 10 aus der Figur 1 in einer Draufsicht, wobei an dem ersten Gehäuse 100 der Stulp 15 angeordnet ist. Im ersten Gehäuse 100 ist die erste Platine 30 und die zweite Platine 40 angeordnet, die miteinander elektrisch sowie elektronisch verbunden sind. Das Einsteckschloss 10 weist in der Figur 2 ein Dornmaß W auf, welches sich von der Mitte einer Schließzylinderöffnung 110 für einen Schließzylinder bis zur Außenkante des Stulpes 15 erstreckt. Das Dornmaß kann auch von der Mitte einer nicht dargestellten Drückeraufnahme für einen Türdrücker bis zur Außenkante des Stulpes 15 angegeben werden.

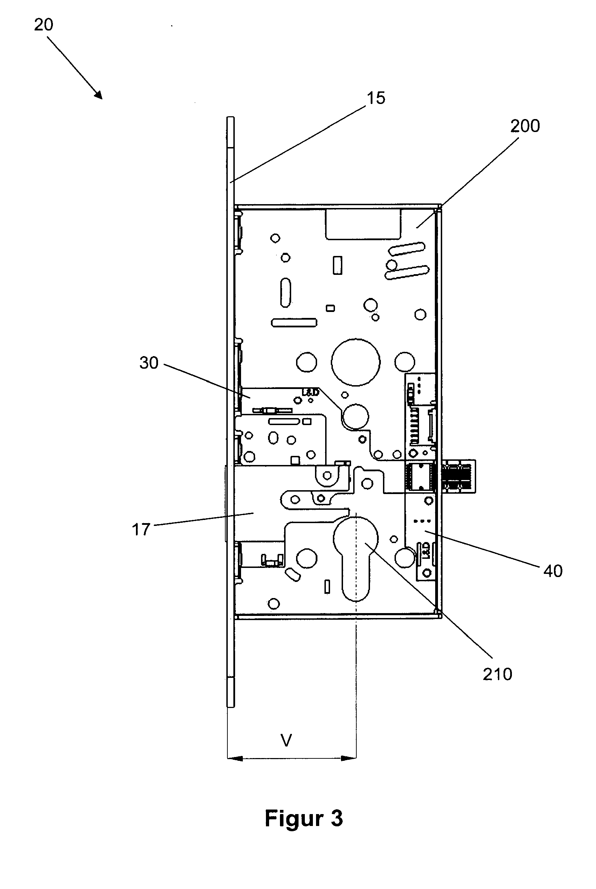

Figur 3 zeigt ein zweites Einsteckschloss 20 in einer Draufsicht, wobei eine Gehäuseabdeckung wurde, um einen Einblick in ein zweites Gehäuse 200 zu ermöglichen. Zur besseren Übersicht ist die Schlossmechanik ebenfalls entfernt, da sie für die Darstellung der Erfindung unerheblich ist. An dem zweiten Gehäuse 200 ist ein Stulp 15 angeordnet, der Öffnungen aufweist, wobei eine dieser Öffnungen durch einen Riegel 17 genutzt wird, um ihn aufgrund der nicht dargestellten Schlossmechanik in das zweite Gehäuse 200 hinein oder herausführen zu können. In der Figur 3 ist erkennbar, dass die erste Platine 30 mit einem Teilbereich aus dem zweiten Gehäuse 200 herausragt, wodurch dargestellt wird, dass die erste Platine 30 zu bearbeiten ist, um sie funktionssicher für dieses zweite Einsteckschloss 20 bereitzustellen. Das zweite Einsteckschloss 20 weist in der Figur 3 ein Dornmaß V auf, welches sich von der Mitte der Schließzylinderöffnung 210 für einen Schließzylinder bis zur Außenkante des Stulpes 15 erstreckt, wobei die Schließzylinderöffnung 210 in dem zweiten Gehäuse 200 vorhanden ist. Das Dornmaß kann auch von der Mitte einer nicht dargestellten Drückeraufnahme für einen Türdrücker bis zur Außenkante des Stulpes 15 angegeben werden.

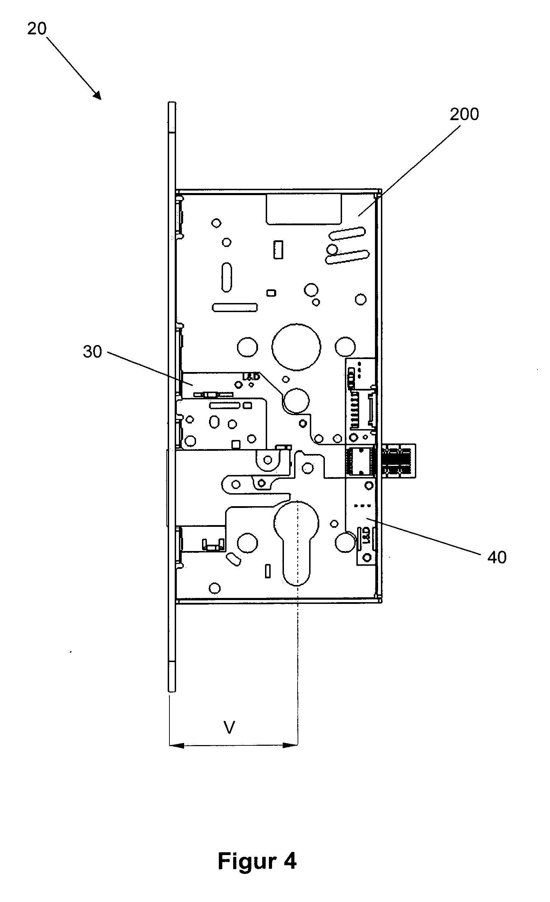

Figur 4 zeigt das zweite Einsteckschloss 20 mit dem Dornmaß V aus der Figur 3, wobei die erste Platine 30 bearbeitet und in das zweite Gehäuse 200 angeordnet ist, wobei die erste Platine 30 mit der zweiten Platine 40 elektrisch sowie elektronisch verbunden ist.

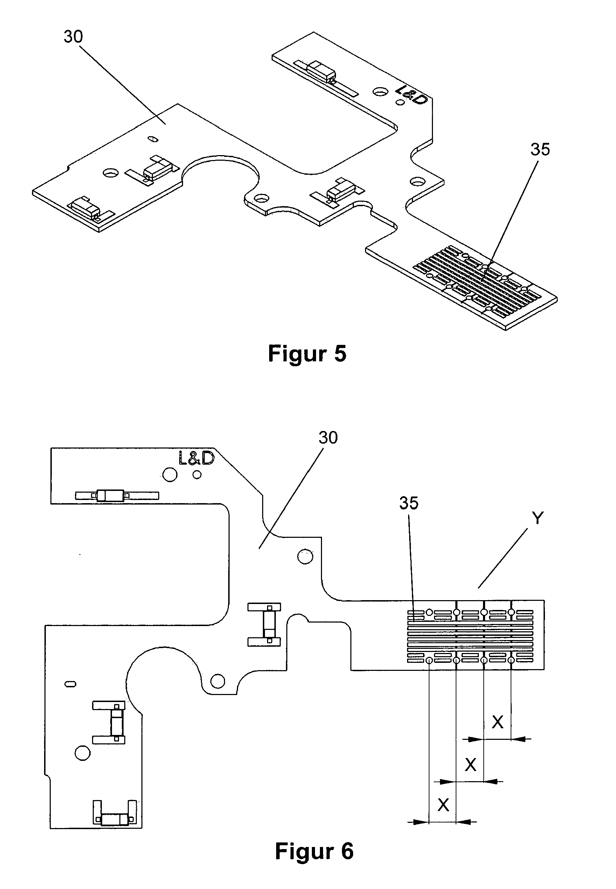

Figur 5 zeigt die erste Platine 30 in einer perspektivischen Ansicht, wobei die erste Platine 30 einen Abschnitt besitzt, bei dem ein Kontaktpad 35 angeordnet ist. Das Kontaktpad 35 weist Leiterbahnen auf, die von einem Leiterplattenverbinder 50 kontaktierbar sind.

Figur 6 zeigt die erste Platine 30 in einer Draufsicht, wobei das Kontaktpad 35 Abstufungen X aufweist. Der Abschnitt der ersten Platine 30, bei dem das Kontaktpad 35 angeordnet ist, ist von einer Detailangabe Y gekennzeichnet.

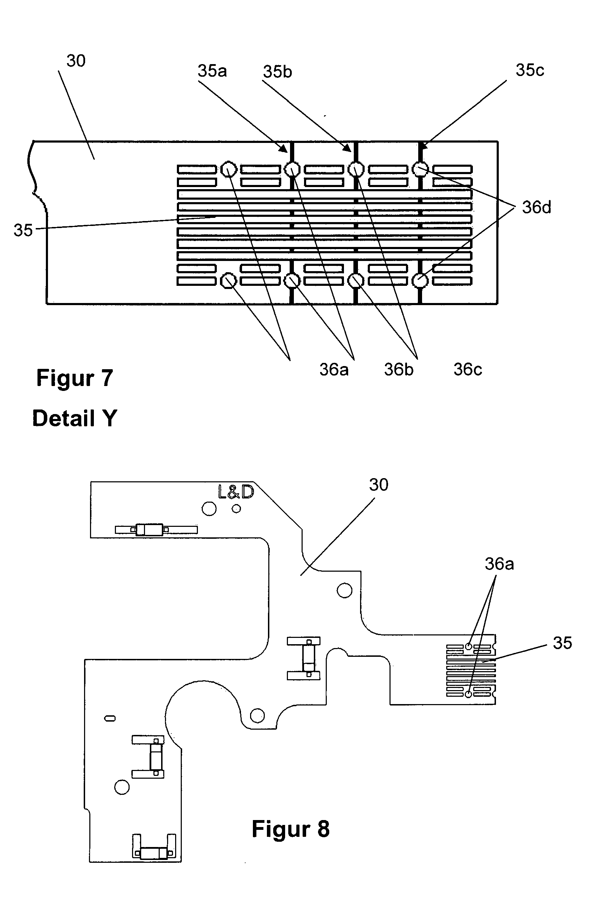

Figur 7 zeigt die Detailangabe Y aus der Figur 6 vergrößert dargestellt. Der Abschnitt des Kontaktpads 35 der ersten Platine 30 beinhaltet erste Zentrierbohrungen 36a sowie eine erste Schneidkante 35a, auf deren Ebene zweite Zentrierbohrungen 36b angeordnet sind, sowie eine zweite Schneidkante 35b, auf deren Ebene dritte Zentrierbohrungen 36c angeordnet sind und eine dritte Schneidkante 35c, auf deren Ebene vierte Zentrierbohrungen 36d angeordnet sind.

Figur 8 zeigt die erste Platine 30, die derart bearbeitet ist, dass ein Teilbereich des Kontakpads 35 entfernt ist, wobei der entfernte Teil ab der Schneidkante 35a entfernt ist, wodurch die Zentrierbohrungen 36a an dem Kontaktpad 35 weiterhin Bestand haben.

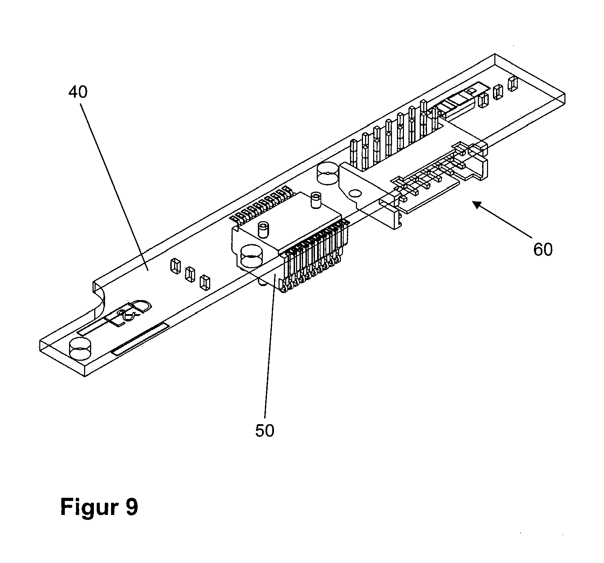

Figur 9 zeigt die zweite Platine 40 in einer perspektivischen Ansicht, wobei an der zweiten Platine 40 ein Leiterplattenverbinder 50 sowie ein Steckkontakt 60 angeordnet sind.

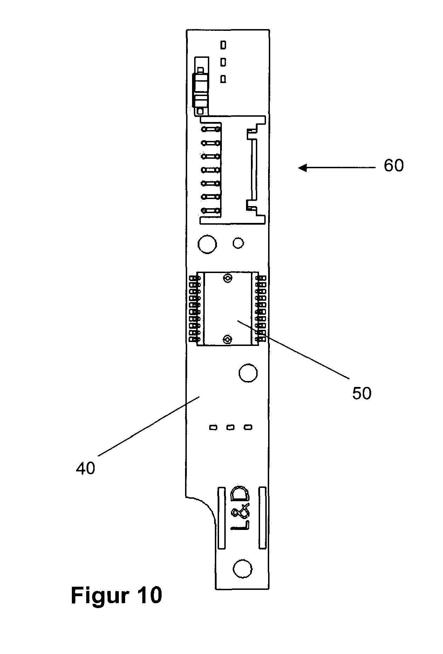

Figur 10 zeigt die zweite Platine 40 aus der Figur 9 in einer Draufsicht, wobei der Leiterplattenverbinder 50 und der Steckkontakt 60 dargestellt sind.

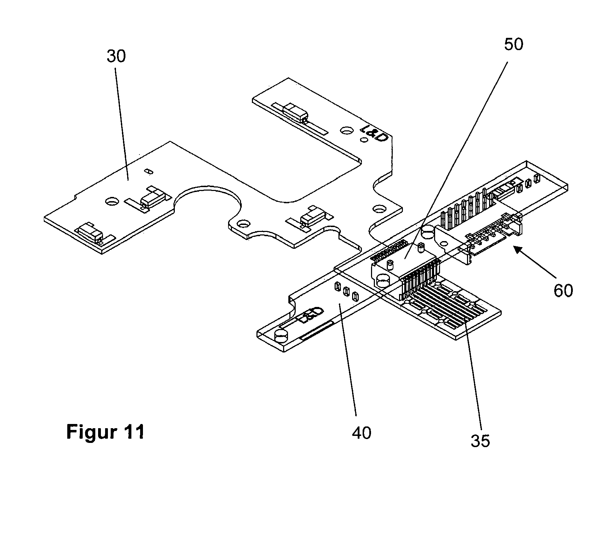

Figur 11 zeigt die Platine in einer perspektivischen Ansicht, wobei die erste Platine 30 und die zweite Platine 40 in ihrer Funktionslage aufgrund eines Leiterplattenverbinders 50 miteinander verbunden sind. Dabei kontaktiert der Leiterplattenverbinder 50 das Kontaktpad 35.

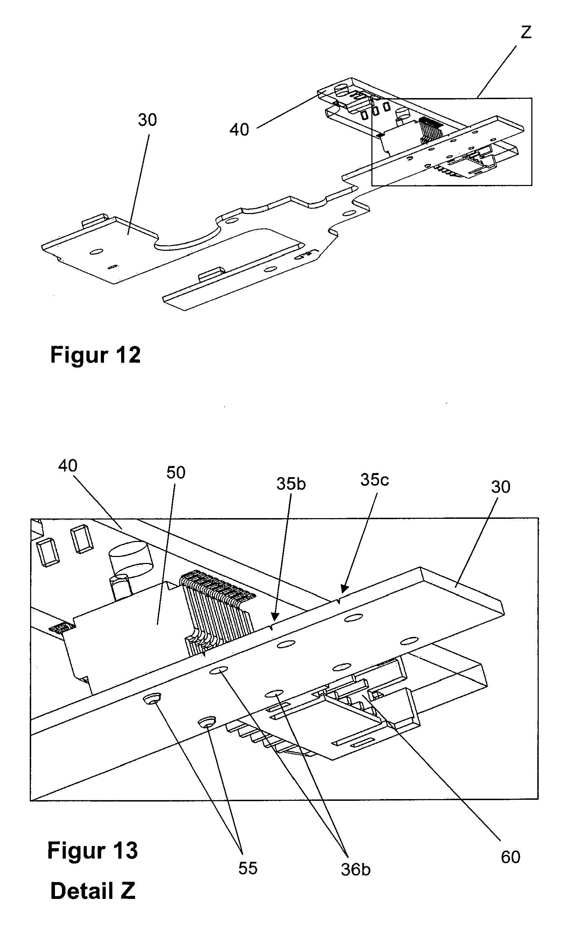

Figur 12 zeigt die Platine aus der Figur 11 in einer weiteren perspektivischen Ansicht, wobei eine Detailangabe Z einen Teilbereich der verbundenen ersten Platine 30 mit der zweiten Platine 40 kennzeichnet.

Figur 13 zeigt die Detailangabe Z aus der Figur 12 vergrößert dargestellt. Die erste Platine 30 weist Schneidkanten auf, von denen in der Figur 13 die Schneidkanten 35b und 35c kenntlich gemacht sind. Die erste Platine 30 ist aufgrund des Leiterplattenverbinders 50 mit der zweiten Platine 40 verbunden, wobei Zentrierdome 55 des Leiterplattenverbinders 50 in die ersten Zentrierbohrungen 36a eingreifen, wodurch die zweite Platine 40 zu der ersten Platine 30 ausgerichtet und zentriert ist. Die Kontaktierung zwischen der ersten Platine 30 und der zweiten Platine 40 erfolgt aufgrund des Leiterplattenverbinders 50, wobei der Leiterplattenverbinder 50 das Kontaktpad 35 kontaktiert. Die Zentrierbohrungen der ersten Platine 30 sind erkennbar, wobei in der Figur 13 lediglich die Zentrierbohrungen 36b kenntlich gemacht sind. In diese Detailansicht ist der Steckkontakt 60 ebenfalls erkennbar.

Bei der Erfindung handelt es sich um Einsteckschlösser mit einer Platine, wobei die Einsteckschlösser unterschiedliche Dornmaße aufweisen können, wie beispielsweise die Einsteckschlösser 100, 200. Die Platine ist aus einer ersten Platine 30 und einer zweiten Platine 40 gebildet, die aufgrund eines Leiterplattenverbinders 50 miteinander elektrisch und elektronisch verbunden sind. Die erste Platine 30 weist ein Kontaktpad 35 auf, an dem Paare von Zentrierbohrungen 36a, 36b, 36c, 36d sowie Schneidkanten 35a, 35b, 35c angeordnet sind. Ein Paar von Zentrierbohrungen 36a, 36b, 36c, 36d besitzt zu dem benachbarten Paar von Zentrierbohrungen 36a, 36b, 36c, 36d eine Beabstandung, die einer Dornmaßstufung X von z. B. 5mm entspricht. Das Kontaktpad 35 ist derart ausgebildet, dass Paare von Zentrierbohrungen 36b, 36c, 36d auf einer Ebene der Schneidkanten 35a, 35b, 35c angeordnet sind, wobei das Kontaktpad 35 Leiterbahnen aufweist, die mit Leiterbahnen des Leiterplattenverbinders 50 korrespondieren.

Bei der Verwendung eines ersten Einsteckschlosses 10 mit einem ersten Gehäuse 100 ist ein Dornmaß des ersten Gehäuses W vorhanden, welches es zulässt, die Platine in das erste Gehäuse 100 zu montieren, ohne einen Teilbereich des Kontaktpads entfernen zu müssen.

Bei der Verwendung eines zweiten Einsteckschlosses 20 mit einem zweiten Gehäuse 200 ist ein Dornmaß des zweiten Gehäuses V vorhanden, wobei das Dornmaß des zweiten Gehäuses V geringer ist als das Dornmaß des ersten Gehäuses W. Um die Platine in das zweite Gehäuse 200 montieren zu können, ist es erforderlich, einen Teilbereich des Kontaktpads 35 zu entfernen, welches von Hand oder durch ein Werkzeug erfolgt. Bei der Entfernung eines Teilbereiches des Kontaktpads 35 wird eine der Schneidkanten 35a, 35b, 35c genutzt, die zur Entfernung des Teilbereiches als Unterstützung dienlich sind. Welche der Schneidkanten 35a, 35b, 35c zur Entfernung eines Teilbereiches des Kontaktpads 35 genutzt wird, ist abhängig von dem Einsteckschloss und hierbei von dem Dornmaß, welches das Einsteckschloss besitzt.

Wird beispielsweise das zweite Einsteckschloss 20 verwendet, welches ein Dornmaß des zweiten Gehäuses V besitzt, so ist die erste Schneidkante 35a zu nutzen, um einen überschüssigen Teilbereich des Kontaktpads 35 zu entfernen, wie in der Figur 8 dargestellt. Hierdurch ist die Platine in das zweite Gehäuse 200 des Einsteckschlosses 20 montierbar. Dabei werden die Zentrierdome 55 in die ersten Zentrierbohrungen 36a eingeführt.

Wird die zweite Schneidkante 35b zur Entfernung eines überschüssigen Teilbereiches des Kontaktpads 35 genutzt, so werden die Zentrierdome 55 in die zweiten Zentrierbohrungen 36b eingeführt. Es ist denkbar, dass in diesem Fall die Zentrierdome 55 in die ersten Zentrierbohrungen 36a eingeführt sein können. Wird die dritte Schneidkante 35c zur Entfernung eines überschüssigen Teilbereiches des Kontaktpads 35 genutzt, so werden die Zentrierdome 55 in die dritten Zentrierbohrungen 36c eingeführt. Es ist denkbar, dass in diesem Fall die Zentrierdome 55 in die ersten Zentrierbohrungen 36a oder in die zweiten Zentrierbohrungen 36b eingeführt sein können.

Das Kontaktpad 35 der ersten Platine 30 ist derart ausgebildet, dass auf der Ebene der Schneidkante 35a die Zentrierbohrungen 36b angeordnet sind, wobei auf der Ebene der Schneidkante 35b die Zentrierbohrungen 36c angeordnet sind und auf der Ebene der Schneidkante 35c die Zentrierbohrungen 36d angeordnet sind.

Die erste Schneidkante 35a besitzt zur zweiten Schneidkante 35b eine Beabstandung, die einer Dornmaßstufung X entspricht. Auch die Schneidkante 35b besitzt zur Schneidkante 35c eine Beabstandung, die ebenfalls einer Dornmaßstufung X entspricht.

Da die zweiten Zentrierbohrungen 36b auf der Ebene der ersten Schneidkante 35a angeordnet sind, und die dritten Zentrierbohrungen 36c auf der Ebene der zweiten Schneidkante 35b angeordnet sind sowie die vierten Zentrierbohrungen 36d auf der Ebene der dritten Schneidkante 35c angeordnet sind, besitzen die zweiten Zentrierbohrungen 36b zu den dritten Zentrierbohrungen 36c eine Beabstandung, die einer Dornmaßstufung X entspricht, wobei die dritten Zentrierbohrungen 36c zu den vierten Zentrierbohrungen 36d ebenfalls eine Beabstandung besitzen, die auch einer Dornmaßstufung X entspricht. Die ersten Zentrierbohrungen 36a sind derart an dem Kontaktpad 35 der Platine 30 angeordnet, dass sie ebenfalls eine Beabstandung zu den zweiten Zentrierbohrungen 36b aufweisen, die ebenfalls einer Dornmaßstufung X entspricht.

Ist ein Teilbereich des Kontaktpads 35 der ersten Platine 30 entfernt worden, oder ist eine Entfernung eines Teilbereiches nicht erforderlich, wird aufgrund des Leiterplattenverbinders 50 die erste Platine 30 mit der zweiten Platine 40 elektrisch und elektronisch verbunden, wobei die Zentrierdome 55 in ein Paar der Zentrierbohrungen 36a, 36b, 36c, 36d eingeführt sind und der Leiterplattenverbinder 50 das Kontaktpad 35 kontaktiert. Der Leiterplattenverbinder 50 ist werkseitig an der zweiten Platine 40 angeordnet, wobei der Leiterplattenverbinder 50 einen Steckkontakt 60 aufweist, um die Platine aufgrund eines Steckers an einer Energiequelle anschließen zu können. Dieser Stecker wird von außerhalb des Gehäuses 100, 200 durch eine Öffnung 105 des Gehäuses 100, 200 hindurch in das Innere des Gehäuses 100, 200 geführt, um zu dem Steckkontakt 60 der Platine zu gelangen.

Somit kann in Abhängigkeit des jeweiligen Dornmaßes eine Platine verwendet werden, bei der bei Erfordernis ein Teilbereich entfernt werden kann, um die Platine funktionssicher in ein Gehäuse 100, 200 montieren zu können.

Die vorhergehende Beschreibung der vorliegenden Erfindung dient nur zu illustrativen Zwecken und nicht zum Zwecke der Beschränkung der Erfindung. Im Rahmen der durch die Patentansprüche definierten Erfindung sind verschiedene Änderungen und Modifikationen möglich, ohne den Umfang der Erfindung sowie ihrer Äquivalente zu verlassen.

### Bezugszeichenliste

- 10: erstes Einsteckschloss
- 15: Stulp
- 17: Riegel
- 20: zweites Einsteckschloss
- 30: erste Platine
- 35: Kontaktpad
- 35a: erste Schneidkante
- 35b: zweite Schneidkante
- 35c: dritte Schneidkante
- 36a: erste Zentrierbohrungen
- 36b: zweite Zentrierbohrungen
- 36c: dritte Zentrierbohrungen
- 36d: vierte Zentrierbohrungen
- 40: zweite Platine
- 50: Leiterplattenverbinder
- 55: Zentrierdome
- 60: Steckkontakt
- 100: erstes Gehäuse
- 110: Schließzylinderöffnung
- 105: Öffnung
- 200: zweites Gehäuse
- 210: Schließzylinderöffnung
- W: Dornmaß des ersten Gehäuses
- V: Dornmaß des zweiten Gehäuses
- X: Dornmaßstufung

## Patentansprüche

1. Einsteckschloss mit einer Platine zur Verwendung von Zustandsabfragen und/oder motorischen Steuerungen von einzelnen Komponenten des Einsteckschlosses, wobei die Platine einen Steckkontakt (60) aufweist, der im Bereich einer Öffnung (105) am Einsteckschloss von außen zugänglich ist, **dadurch gekennzeichnet, dass** die Platine aus einer ersten und einer zweiten Platine (30, 40) besteht, die mit einem Leiterplattenverbinder (50) und einem Kontaktpad (35) verbunden sind, wobei auf der ersten Platine (30) das Kontaktpad (35) angeordnet ist, welches an ein Dornmaß des Einsteckschlosses anpassbar ist, und dass auf der zweiten Platine (40) der Leiterplattenverbinder (50) und der Steckkontakt (60) angeordnet sind.

2. Einsteckschloss nach Anspruch 1, **dadurch gekennzeichnet, dass** der Kontaktpad (35) Leiterbahnen aufweist.

3. Einsteckschloss nach Anspruch 1, **dadurch gekennzeichnet, dass** an dem Kontaktpad (35) Schneidkanten (35a, 35b, 35c) ausgebildet sind.

4. Einsteckschloss nach einem der vorstehenden Ansprüche, **dadurch gekennzeichnet, dass** das Kontaktpad (35) Paare von Zentrierbohrungen (36a, 36b, 36c, 36d) aufweist.

5. Einsteckschloss nach einem der vorstehenden Ansprüche, **dadurch gekennzeichnet, dass** an dem Leiterplattenverbinder (50) Zentrierdome (55) angeordnet sind.

6. Einsteckschloss nach einem der Ansprüche 4-5, **dadurch gekennzeichnet, dass** die Zentrierbohrungen (36a, 36b, 36c, 36d) mit den Zentrierdomen (55) zusammenwirken.

7. Einsteckschloss nach einem der Ansprüche 4-6, **dadurch gekennzeichnet, dass** benachbarte Paare von Zentrierbohrungen (36a, 36b, 36c, 36d) jeweils eine Beabstandung aufweisen, die einer Dornmaßstufung (X) entspricht.

8. Einsteckschloss nach einem der Ansprüche 4-7, **dadurch gekennzeichnet, dass** die paarweise angeordneten Zentrierbohrungen (36b, 36c, 36d) auf einer Ebene von zugeordneten Schneidkanten (35a, 35b, 35c) angeordnet sind.

9. Einsteckschloss nach Anspruch 8, **dadurch gekennzeichnet, dass** aufgrund der Schneidkante (35a, 35b, 35c) ein Teilabschnitt des Kontaktpads (35) von Hand oder einem Werkzeug entfernbar ist.

10. Einsteckschloss nach einem der Ansprüche 5-9, **dadurch gekennzeichnet, dass** der Leiterplattenverbinder (50) bei der Verbindung der ersten Platine (30) mit der zweiten Platine (40) aufgrund der Zentrierdome (55) und den Zentrierbohrungen (36a, 36b, 36c, 36d) die zweite Platine (40) zu der ersten Platine (30) ausrichtet und zentriert.

11. Einsteckschloss nach einem der Ansprüche 5-10, **dadurch gekennzeichnet, dass** die Zentrierdome (55) in die paarweise angeordneten Zentrierbohrungen (36a, 36b, 36c, 36d) des Kontaktpads (35) einführbar sind.

12. Einsteckschloss nach einem der vorstehenden Ansprüche, **dadurch gekennzeichnet, dass** der Leiterplattenverbinder (50) die Leiterbahnen des Kontaktpads (35) kontaktiert.

## Claims

1. A mortise lock with a printed circuit board utilized for status inquiries and/or for motorized controls of individual components of the mortise lock, the printed circuit board including a plug-in contact (60), which is accessible from outside in the area of an opening (105) at the mortise lock, **characterized in that** the printed circuit board consists of a first and a second printed circuit boards (30, 40), which are connected to a printed circuit board connector (50) and to a contact pad (35), wherein the contact pad (35), which is adaptable to a backset of the mortise lock, is disposed on the first printed circuit board (30), and **in that** the printed circuit board connector (50) and the plug-in contact (60) are disposed on the second printed circuit board (40).

2. The mortise lock according to claim 1, **characterized in that** the contact pad (35) includes conducting paths.

3. The mortise lock according to claim 1, **characterized in that** cutting edges (35a, 35b, 35c) are configured at the contact pad (35).

4. The mortise lock according to any of the preceding claims, **characterized in that** the contact pad (35) includes pairs of centering boreholes (36a, 36b, 36c).

5. The mortise lock according to any of the preceding claims, **characterized in that** centering pins (55) are disposed at the printed circuit board connector (50).

6. The mortise lock according to any of the claims 4 to 5, **characterized in that** the centering boreholes (36a, 36b, 36c, 36d) cooperate with the centering pins (55).

7. The mortise lock according to any of the claims 4 to 6, **characterized in that** neighbouring pairs of centering boreholes (36a, 36b, 36c, 36d) respectively include a spacing which corresponds to a backset grading (X).

8. The mortise lock according to any of the claims 4 to 7, **characterized in that** the centering boreholes (36b, 36c, 36d) disposed in pairs are disposed in one plane of assigned cutting edges (35a, 35b, 35c).

9. The mortise lock according to claim 8, **characterized in that**, due to the presence of the cutting edge (35a, 35b, 35c), a partial section of the contact pad (35) can be removed by hand or with a tool.

10. The mortise lock according to any of the claims 5 to 9, **characterized in that**, when connecting the first printed circuit board (30) to the second printed circuit board (40), the printed circuit board connector (50) aligns and centers the second printed circuit board (40) with regard to the first printed circuit board (30) by means of the centering pins (55) and the centering boreholes (36a, 36b, 36c, 36d).

11. The mortise lock according to any of the claims 5 to 10, **characterized in that** the centering pins (55) can be introduced into the centering boreholes (36a, 36b, 36c, 36d) of the contact pad (35) which boreholes are disposed in pairs.

12. The mortise lock according to any of the preceding claims, **characterized in that** the printed circuit board connector (50) contacts the conducting paths of the contact pad (35).

## Revendications

1. Serrure à mortaise avec une platine utilisée pour des interrogations d'état et/ou des contrôles par moteur de composants individuels de la serrure à mortaise, la platine présentant un contact à fiches (60) qui, dans la région d'une ouverture (105) sur la serrure à mortaise, est accessible de l'extérieur, **caractérisée en ce que** la platine consiste en une première et une second platine (30, 40), qui sont connectées à un connecteur de cartes de circuits imprimés (50) et à une plage de contact (35), la plage de contact (35) étant agencée sur la première platine (30) et pouvant être adaptée à une dimension d'ardillon de la serrure à mortaise, et **en ce que** le connecteur de cartes de circuits imprimés (50) et le contact à fiches (60) étant agencés sur la seconde platine (50).

2. Serrure à mortaise selon la revendication 1, **caractérisée en ce que** la plage de contact (35) présente des circuits conducteurs.

3. Serrure à mortaise selon la revendication 1, **caractérisée en ce que** des bords coupants (35a, 35b, 35c) sont aménagés sur la plage de contact (35).

4. Serrure à mortaise selon l'une des revendications précédentes, **caractérisée en ce que** la plage de contact (35) présente des pairs de perçages de centrage (36a, 36b, 36c, 36d).

5. Serrure à mortaise selon l'une des revendications précédentes, **caractérisée en ce que** des bulbes de centrage (55) sont agencés sur le connecteur de cartes de circuits imprimés (50).

6. Serrure à mortaise selon l'une des revendications 4 à 5, **caractérisée en ce que** les perçages de centrage (36a, 36b, 36c, 36d) coopèrent avec des bulbes de centrage (55).

7. Serrure à mortaise selon l'une des revendications 4 à 6, **caractérisée en ce que** des paires avoisinantes de perçages de centrages (36a, 36b, 36c, 36d) respectivement présentent un écartement qui correspond à un aménagement en gradins de l'ardillon (X).

8. Serrure à mortaise selon l'une des revendications 4 à 7, **caractérisée en ce que** les perçages de centrage (36b, 36c, 36d) agencés en paires sont agencés dans un plan de bords coupants (35a, 35b, 35c) conjugués.

9. Serrure à mortaise selon la revendication 8, **caractérisée en ce que**, en raison du bord coupant (35a, 35b, 35c), une section partielle de la plage de contact (35) peut être enlevée à la main ou avec un outil.

10. Serrure à mortaise selon l'une des revendications 5 à 9, **caractérisée en ce que**, lors d'une connexion de la première platine (30) à la second platine (40), le connecteur de cartes de circuits imprimés (50) aligne et centre la second platine (40) par rapport à la première platine (30) par l'intermédiaire des bulbes de centrage (55) et des perçages de centrage (36a, 36b, 36c, 36d).

11. Serrure à mortaise selon l'une des revendications 5 à 10, **caractérisée en ce que** les bulbes de centrage (55) peuvent être introduits dans les perçages de centrage (36a, 36b, 36c, 36d) agencés en paires de la plage de contact (35).

12. Serrure à mortaise selon l'une des revendications précédentes, **caractérisée en ce que** le connecteur de cartes de circuits imprimés (50) est en contact avec les circuits conducteurs de la plage de contact (35).
